**Europäisches Patentamt**

**European Patent Office**

**Office européen des brevets**

(19)

(11) Veröffentlichungsnummer: **0 228 613**
**B1**

(12)

# EUROPÄISCHE PATENTSCHRIFT

(45) Veröffentlichungstag der Patentschrift:
01.08.90

(51) Int. Cl.⁵: **G01R 31/34**

(21) Anmeldenummer: 86117085.0

(22) Anmeldetag: 08.12.86

(54) Verfahren zur Teilentladungserfassung und Abreissfunkenmessung bei dynamoelektrischen Hochspannungsmaschinen sowie Einrichtung zu seiner Durchführung.

(30) Priorität: **12.12.85 DE 3543927**

(43) Veröffentlichungstag der Anmeldung:
**15.07.87 Patentblatt 87/29**

(45) Bekanntmachung des Hinweises auf die Patenterteilung:
**01.08.90 Patentblatt 90/31**

(84) Benannte Vertragsstaaten:
**CH DE FR GB LI**

(56) Entgegenhaltungen:
**DE-A- 2 920 389**
**DE-C- 411 147**
**US-A- 4 446 426**

**IEE PROCEEDINGS, Band 132, Nr. 5, Teil B, September 1985, Sektion A-I, Seiten 234-244, Stevenage, Herts, GB; A. WILSON et al.: "Discharge detection techniques for stator windings"**

(73) Patentinhaber: **Siemens Aktiengesellschaft, Wittelsbacherplatz 2, D-8000 München 2(DE)**

(72) Erfinder: **Koziel, Reinhold, Zehntweg 215, D-4330 Mülheim/Ruhr(DE)**
Erfinder: **Fork, Kurt, Dr. Dipl.-Ing., Rosenbach Nr. 33, D-8524 Neunkirchen(DE)**
Erfinder: **Weidner, Jürgen, Dipl.-Ing., Am Ehrenmal 35, D-4300 Essen 14(DE)**

**Beschreibung**

Die Erfindung bezieht sich auf ein Verfahren zur Teilentladungserfassung und Abreißfunkenmessung bei dynamoelektrischen Hochspannungsmaschinen, insbesondere zur betriebsmäßigen Überwachung des Isolationszustandes der Ständerwicklung und der angeschlossenen elektrischen Ableitung bei Turbogeneratoren, gemäß Oberbegriff des Anspruchs 1.

Mit der Ankopplungseinheit nach der älteren, noch veröffentlichten Patentanmeldung DE-A 3 526 149.8 läßt sich das gattungsgemäße Verfahren realisieren. Dort ist je eine Ankopplungseinheit, umfassend entsprechende Teilentladungs-Meßeinrichtungen, selektiv an je eine der drei Stränge der Generatorableitung ankoppelbar, zu welchem Zweck die Netzschutzkondensatoren jeder Phase über je eine Meßimpedanz an Erdpotential angeschlossen sind, wobei die vom Meßspannungsanschluß der Meßimpedanz zum Teilentladungsmeßgerät der Teilentladungs-Meßeinrichtung verlegten bzw. geschalteten abgeschirmten Meßleitungen über ein Filter geführt sind.

Diese bereits vorgeschlagene Ankopplungseinheit hat sich sehr bewährt; sie soll durch den Gegenstand der vorliegenden Erfindung zu einem Teilentladungs-Meßsystem vervollkommnet werden, mit dem es möglich ist, die Teilentladungs-Meßsignale über einen zweiten, unabhängigen Signalweg zu erhalten, womit eine Verifizierung und eine Plausibilitätsbetrachtung für die über den ersten Signalweg erhaltenen Teilentladungs-Meßsignale erleichtert ist. Weiterhin soll es duch die vorliegende Erfindung ermöglicht sein, das gattungsgemäße Verfahren zur Teilentladungserfassung und Abreißfunkenmessung anzuwenden und dementsprechend eine Einrichtung zu seiner Durchführung zu installieren, ohne daß die zu überwachende dynamoelektrische Hochspannungsmaschine - insbesondere der Turbogenerator - außer Betrieb genommen werden müßte.

Wie es vorstehend bereits angedeutet wurde, bezieht sich die Erfindung auch auf eine Einrichtung zur Durchführung des gattungsgemäßen Verfahrens, mit einer TeilentladungsMeßeinrichtung, bestehend aus wenigstens einem Teilentladungs-Meßgerät und an dieses Meßgerät über Koppelfilter angeschlossenen Meßleitungen, insbesondere zur betriebsmäßigen Überwachung des Isolationszustandes der Ständerwicklung und der angeschlossenen elektrischen Ableitungen bei Turbogeneratoren, letztere bestehend aus Ständer mit Ständerwicklung und Ständergehäuse sowie Rotor mit Erregerwicklung und Welle, ferner mit Luftspalt zwischen Rotor und Ständer, wobei die Welle des Rotors an wenigstens einem ölgeschmierten Gleitlager gelagert ist.

Der Erfindung liegt die Aufgabe zugrunde, ein gattungsgemäßes Verfahren zur Teilentladungserfassung und Abreißfunkenmessung sowie eine vorteilhafte Einrichtung zu seiner Durchführung zu schaffen, mit welchem bzw. mit welcher die vorstehend erläuterten Anforderungen erfüllt und demnach die bereits vorgeschlagene Ankopplungseinheit zu einem Teilentladungs-Meßsystem vervollkommnet werden kann.

Verfahrensmäßig wird die gestellte Aufgabe durch die im Kennzeichen des Anspruchs 1 angegebenen Merkmale gelöst.

Eine vorteilhafte Weiterbildung ist im Anspruch 2 angegeben.

Gegenstand der Erfindung ist auch eine Einrichtung zur Durchführung des Verfahrens nach der Erfindung, wie im Oberbegriff des Anspruchs 3 definiert, wobei die Lösung der gestellten Aufgabe durch die im Kennzeichen des Anspruchs 3 angegebenen Merkmale gelingt.

Vorteilhafte Weiterbildungen des Gegenstandes des Anspruchs 3 sind in den Ansprüchen 4 bis 7 angegeben.

Die mit der Erfindung erzielbaren Vorteile sind vor allem darin zu sehen, daß die Einrichtung zur Durchführung des Verfahrens nach der Erfindung installierbar und demgemäß das Verfahren selbst auch dann anwendbar sind, wenn die dynamoelektrische Maschine also insbesondere ein Turbogenerator mit Erregereinrichtung, in Betrieb ist. Das erspart Stillstandzeiten und läßt bereits eine zuverlässige Teilentladungs-Überwachung zu. Wenn dann die Hochspannungsmaschine wegen Inspektions- oder Revisionsarbeiten ohnehin vom Netz abgeschaltet werden muß, dann kann das gesamte Teilentladungs-Überwachungssystem installiert werden, d.h. die Ankopplungseinheit nach der älteren Anmeldung DE-A 3 526 149.8, welche zusammen mit der Einrichtung nach der vorliegenden Erfindung das Teilentladungs-Überwachungssystem ergibt. Ein weiterer wesentlicher Vorteil ist darin begründet, daß die induktive und/ oder kapazitive Ankopplung an die als gestreckten Dipol zu betrachtende Welle auf bequeme Weise möglich ist; man ist nicht an die zur eigentlichen Hochspannungsmaschine gehörende Wellenpartie gebunden, sondern kann die Ankopplung außerhalb derselben im Bereich der Erregereinrichtung vornehmen, wobei sich hier die Ankopplung im Bereich eines Erregerlagers besonders empfiehlt.

Im folgenden werden anhand eines in der Zeichnung dargestellten Ausführungsbeispiels das Verfahren nach der Erfindung und die Einrichtung zu seiner Durchführung noch näher erläutert. Darin zeigt in vereinfachter Darstellung unter Fortlassung der für das Verständnis der Erfindung nicht erforderlichen Teile:

Fig. 1 die Erregereinrichtung eines Turbogenerators im Aufriß, zum Teil im Längsschnitt;
Fig. 2 einen Querschnitt nach der Schnittebene II-II aus Fig. 1;
Fig. 3 schematisch im Aufriß die auf Teilentladungen zu überwachende dynamoelektrische Hochspannungsmaschine in Form eines Turbogenerators zusammen mit der zugehörigen Erregereinrichtung;
Fig. 4 stark schematisiert die kapazitive Auskopplung von Teilentladungs-Meßsignalen aus einem Wellenlager und
Fig. 5 das zugehörige Ersatzschaltbild;
Fig. 6 die auf einer elliptischen Zeitachse mit einem Zweistrahl-Oszillographen dargestellte 50 Hz-Grundwelle der Ständerwicklungsphasen des zu überwachenden Turbogenerators mit dem aufgeprägten Grundstörpegel, dem relativ hohe Abreißfunkenimpulse überlagert sind, und

Fig. 7 in entsprechender Darstellung zu Fig. 6 ein als störungsfrei anzusprechendes Diagramm der Teilentladungs-Verhältnisse in den Phasen der Generator-Ständerwicklung, wobei die feinen Spitzen durch Schaltvorgänge bedingt sind, die von den Dioden eines rotierenden Gleichrichterrades hervorgerufen werden.

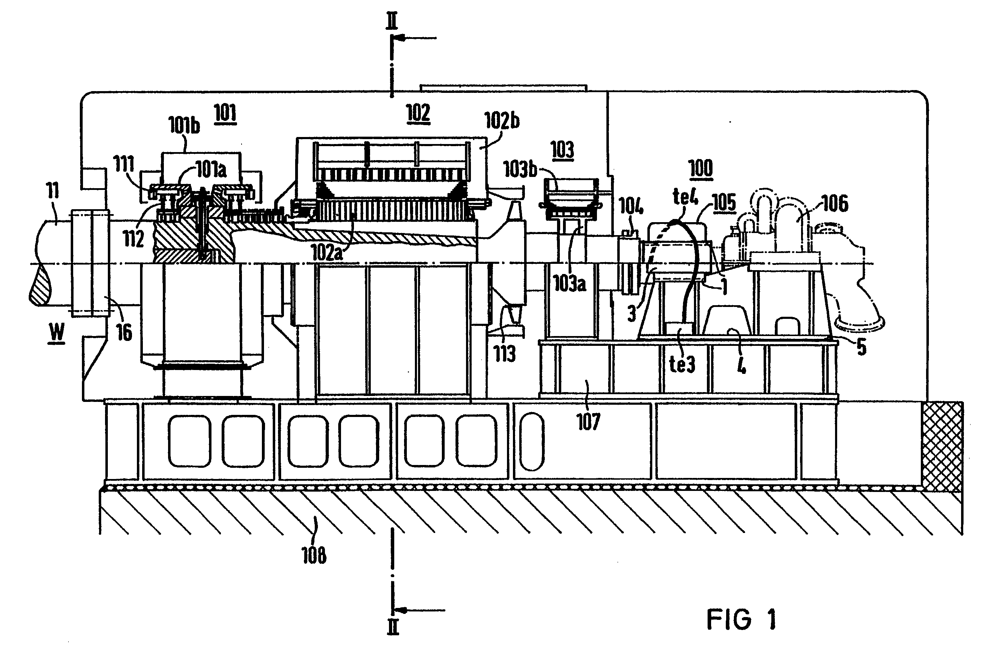

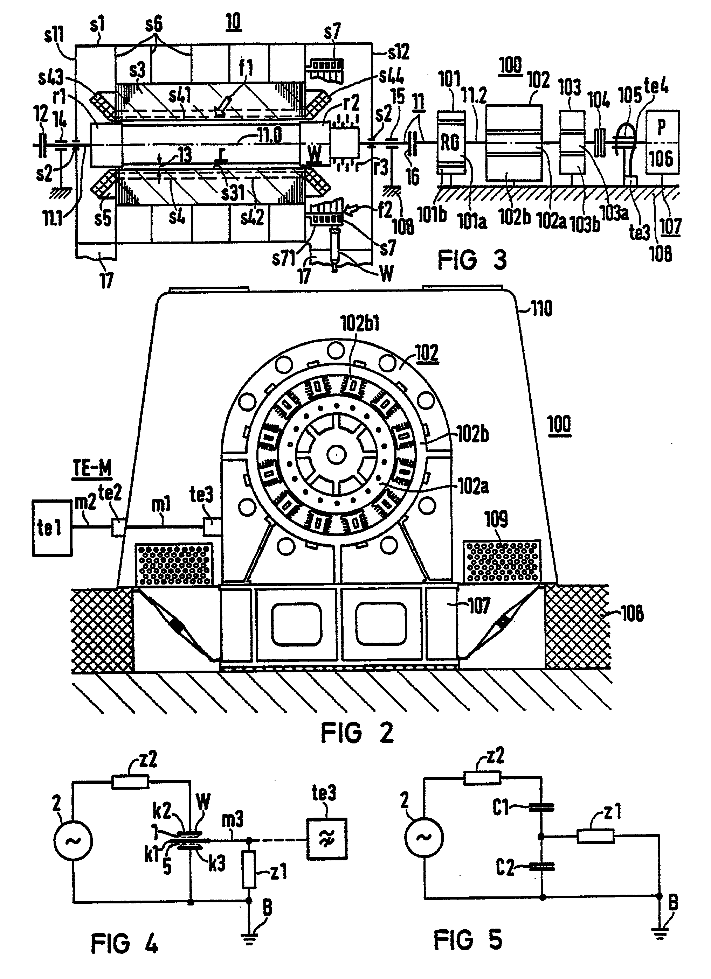

In den Figuren 1 bis 3 ist ein Turbogenerator 10 mit Erregereinrichtung 100 dargestellt, wobei an die gemeinsame Welle 11 über die Wellenkupplung 12 am linken Ende die Welle einer nicht dargestellten Antriebsturbine angekuppelt zu denken ist, bei der es sich um eine Dampf- oder eine Gasturbine handeln kann. Im folgenden wird zunächst auf die schematische Übersichtsdarstellung nach Fig. 3 Bezug genommen.

Der Rotor r, welcher mit einer nicht dargestellten Feld-oder Erregerwicklung versehen ist, bildet einen Teil des Wellenstranges 11; er ist an seinen beiden Enden mit je einer Wickelkopfkappe r1, r2 versehen. Außerdem ist am rechten Ende des Rotors r ein mehrstufiger Axialverdichter r3 dargestellt, welcher das Kühlgas, z.B. H₂ (bei kleineren Maschinen:Luft) zur Kühlung im Maschineninneren umwälzt, welches von einem Gehäusemantel s1 nach außen begrenzt wird, wobei dichtende Wellendurchführungen im Bereich der Gehäusestirnwände s11, s12 bei s2 angedeutet sind. Der Rotor r wird mit Ringspalt 13, üblicherweise als Luftspalt bezeichnet, vom Ständerblechpaket s3 umgeben, und am Umfang der Ständerblechpaket-Bohrung s31 sind in entsprechenden Längsnuten des Ständerblechpaketes s3 über dessen Umfang verteilt die Ständerwicklungsstäbe s4 eingelegt, welche üblicherweise innerhalb der jeweiligen Nut aus einem Oberstab s41 und aus einem Unterstab s 42 bestehen. Im Bereich der beiden Wickelköpfe s43, s44 sind die Ständerwicklungsstäbe zu einer dreiphasigen Drehstromwicklung elektrisch miteinander verbunden, wobei die Wickelköpfe s43, s44 durch nicht näher dargestellte Wickelkopf-Halterungen s5 gegen Stromkräfte fixiert sind, wobei aber trotzdem eine thermisch bedingte Längenänderung der Ständerwicklungsstäbe s4 ermöglicht ist. Das Ständerblechpaket s3 ist innerhalb einer Rahmenkonstruktion des Ständers s6 zentrisch zur Welle 11 bzw. ihrer Achslinie 11.0 gehalten. Mit s7 sind im Ausschnitt dargestellte Ringleitungen bezeichnet, welche mit entsprechenden ringförmigen Spanngliedern s71 am Ständer s6 befestigt sind. Diese Ringleitungen s7 dienen der Verschaltung der Ständerwicklung derart, daß durch Zusammenschaltung der Schleifen- oder Wellenwicklungen der Ober- und Unterstäbe der Ständerwicklung s4 drei Phasen-Ableitungen U, V und W aus der Maschine isoliert herausgeführt werden können, wobei die Durchführung W für die Phase W in Fig. 3 angedeutet ist.

Der dargestellte Teil des Wellenstranges 11 ist an beiden Stirnseiten des Generators 10 an Radiallagern 14, 15 gelagert; zwischen dem zum Generator 10 gehörenden Teil 11.1 der Welle und dem zur Erregereinrichtung 100 gehörenden Teil 11.2 der Welle ist eine weitere Wellenkupplung 16 eingefügt.

Zur Erregereinrichtung 100 des Turbogenerators 10 gehört ein sogenannter RG-Satz 101, eine Haupterregermaschine 102, eine Hilfserregermaschine 103, eine Meßschleifring-Anordnung 104, ein Erregerlager 105 und - bei Wasserkühlung der Ständerwicklung s4 und ggf. der (nicht dargestellten) Rotorwicklung eine Schaftpumpe 106, von welcher die Kühlflüssigkeit durch die hohle Welle in das Innere des Ständergehäuses s1 geleitet und über entsprechende Rückführkanäle auch wieder zur Pumpe 105 zurückgeleitet wird.

Der RG-Satz 101 besteht aus einem Gleichrichter-Trägerrad 101a, welches mit der Welle 11 umläuft und einem Gehäuse 101b. Die Haupterregermaschine 102 besteht aus einem mit der Welle umlaufenden Anker 102a und - da sie eine Außenpolmaschine ist - aus einem Ständer 102b mit in Fig. 3 nicht näher dargestellten Außenpolen mit Feldwicklung. Den einzelnen Feldwicklungen der Außenpole der Haupterregermaschine wird der Erregerstrom vom stationären Anker 103b der Hilfserregermaschine 103 zugeführt, welche zur Erregung der Ankerwicklung einen mit der Welle umlaufenden Permanentpol-Läufer 103a aufweist. Die elektrischen Verbindungsleitungen zwischen den Komponenten 101, 102 und 103 sind in Fig. 3 nicht dargestellt. Dazu gehören auch Drehstromzuleitungen, welche vom umlaufenden Anker 102a der Haupterregermaschine 102 zu den einzelnen Dioden des Gleichrichterträgerrades 101a geführt sind, wobei letztere insbesondere in Drehstrombrückenschaltung geschaltet sind und auf ihrer Gleichstrom-Ausgangsseite den Erregergleichstrom über in der Welle 11 verlegte Erregerzuleitungen an die Feldwicklung des Rotors r liefern.

Die Komponenten 101, 102, 103, 105 und 106 sind mit ihren stationären Teilen auf einem Tragrahmen 107 abgestützt, welcher auf dem gestrichelt schematisch angedeuteten Fundament 108 ruht. Eine weitere auf dem Fundament ruhende Tragkonstruktion für den Ständer f1 des Turbogenerators 10 ist bei 17 im Ausschnitt angedeutet.

In Fig. 1 und 2 sind die anhand der Fig. 3 erläuterten Komponenten der Erregereinrichtung 100 mit den gleichen Bezugszeichen versehen; darüber hinaus sind noch folgende Details erkennbar: Die als Röhrenwärmetauscher ausgebildeten Kühler 109 für das innerhalb des Gehäusemantels 110 der Erregereinrichtung 100 zirkulierende Kühlgas, insb. Kühlluft; die Magnetpole 102b1 der Haupterregermaschine 102; die elektrischen Schmelzsicherungen 111 für die Dioden 112 des Gleichrichterträgerrades 101a; einen Axiallüfter 113 an der einen Stirnseite der Haupterregermaschine 102. Das Gehäuse 101b des RG-Satzes 101 hat keine tragende Funktion, sondern dient als Luftführungshaube.

Mit der im folgenden erläuterten Teilentladungs-Meßeinrichtung kann das Verfahren zur Teilentladungserfassung und Abreißfunkenmessung bei dynamo-elektrischen Hochspannungsmaschinen nach der Erfindung verwirklicht werden. Ein bevorzugtes Ausführungsbeispiel betrifft den erläuterten Turbogenerator im Leistungsbereich zwischen etwa 50 MVA und 1400 MVA, der einen Vollpolläufer aufweist. Das Verfahren ist indessen auch zur Überwachung von anderen Synchronmaschinen, also z. B. Wasserkraftgeneratoren, deren Läufer ausgeprägte Pole aufweisen, geeignet, oder anderer Hochspannungsmaschinen, bei denen es wichtig ist, während des Betriebes den Zustand der Ständerwicklungsisolation und derjenigen der Ringleitungen oder sonstiger Schaltleitungen zu überwachen. Die Meßeinrichtung nach der Erfindung nutzt aus, daß der Wellenstrang 11 mit seinen Teilwellen 11.1 und 11.2 innerhalb seiner Gleitlager 14, 15, 105 in einem Ölfilm 1 umläuft, der beim Wellenlager 105 gestrichelt angedeutet ist (Fig. 1). Der Wellenstrang 11 stellt also in erster Näherung einen gestreckten Dipol dar. Treten nun innerhalb der Ständerwicklung s4, wie durch den Pfeil f1 angedeutet (s. Figur 3), an irgendeiner Stelle Teilentladungen auf, so verursachen diese Teilentladungen, welche von einem Spannung führenden Ständerwicklungsstab über seine (nicht dargestellte) Stabisolation zum Ständereisen oder zu einem Nachbarstab sich erstrecken, ein breitbandiges Frequenzspektrum hochfrequenter Schwingungen, welches über den Luftspalt 13 im wesentlichen mittels kapazitiver Kopplung in den Rotor r und damit in den Wellenstrang 11 eingekoppelt wird. Bei dieser kapazitiven Übertragung wirkt das Wicklungskupfer des betreffenden Ständerwicklungsstabes als ein kapazitiver Belag, und die Stabisolation sowie der Luftspalt sind als Dielektrikum eines großen Kondensators aufzufassen, dessen anderer Belag die Metallmassen des Rotors r und des Wellenstranges 11 sind. Naturgemäß findet auch eine Übertragung des Frequenzspektrums auf induktivem Wege auf die Einheit aus Rotor und Wellenstrang 11 (im folgenden vereinfachend als Welle W bezeichnet) statt, jedoch zu einem geringeren Anteil. Sinngemäß erfolgt auch die Einkopplung eines breitbandigen Frequenzspektrums hochfrequenter elektromagnetischer Schwingungen, wenn z. B. bei einer der Ringleitungen gemäß Pfeil f2 Teilentladungen auftreten (s. Figur 3). Hierbei ist aber wegen des wesentlich größeren radialen Abstandes der Ringleitungen (dazu kann auch eine Erdungsleitung gehören) der kapazitiv eingekoppelte Anteil kleiner und der induktiv eingekoppelte Anteil größer. Wesentlich ist es nun, zwischen harmlosen Teilentladungsvorgängen und solchen zu unterscheiden, die auf Dauer zu einer Beschädigung der Wicklungsisolation führen können. Selbstverständlich müssen Abreißfunken, welche nichts anderes als besonders große Teilentladungen darstellen, sofort und eindeutig erkannt werden.

Die Teilentladungs-Meßeinrichtung ist als Ganzes mit TE-M bezeichnet (Fig. 2). Sie besteht aus wenigstens einem Teilentladungs-Meßgerät te1 (schematisch als Kasten angedeutet), den insbesondere als Koaxialkabel ausgeführten Meßleitungen m1, m2, einer Hochfrequenz-Steckerbuchse te2 als Meßanschluß zum Meßgerät te1 und einem Koppelfilter te3, welch letzteres z. B. am Gehäusemantel 102b der Haupterregermaschine 102 befestigt ist. Vom Koppelfilter ist ein erstes Stück m1 der Meßleitung zur Hochfrequenzbuchse te2 verlegt, und von letzterer führt das zweite Stück m2 der Meßleitung

zum Meßgerät te1. Das Meßleitungsstück m2 ist insbesondere ein flexibles Koaxialkabel ausreichender Länge, so daß das Meßgerät te1 an einem Meßplatz entfernt von der Erregereinrichtung 100 aufgestellt werden kann.

Das Koppelfilter te3 ist in seiner axialen Positionierung aus Fig. 3 und - noch detaillierter - aus Fig 1 erkennbar. An seiner Eingangsseite ist eine induktive Koppelschleife te4 mit ihrem einen Ende elektrisch angeschlossen, das andere Ende der Koppelschleife te4 ist um das Gehäuse des Erregerlagers 105 herumgelegt. Diese induktive Koppelschleife bestand in einer Versuchsausführung aus einem isolierten Kupferdraht von 2,5 mm² Querschnitt und etwa 2,5 m Länge. Die Koppelschleife dient nun als Empfangsantenne, welche an das Dipolfeld der Maschinenwelle W angekoppelt und ausgangsseitig, bevorzugt über das Koppelfilter te3, an die Meßleitung m1 angeschlossen ist (die Meßleitung m1 ist in Fig. 1 und Fig. 3 nicht dargestellt). Der Vorteil einer solchen induktiven Koppelschleife ist ihre Beweglichkeit: sie kann zunächst probeweise an verschiedenen Stellen der Welle W innerhalb der Erregereinrichtung 100 positioniert werden, und auch der von der Schleife umfaßte Ortsvektor kann durch Verdrehen der Schleife solange geändert werden, bis das größte Nutzsignal empfangen wird. Zusätzlich zu der induktiven Ankopplung mittels Koppelschleife kann aber zur Gewinnung von Teilentladungs-Meßsignalen auf einem zweiten Meßweg über eine Ankopplungsimpedanz z1 (vgl. Fig. 4) eine Meßleitung m3 an einen Kapazitätsbelag k1 galvanisch angeschlossen sein, welcher Kapazitätsbelag k1 durch einen zur Welle W und zum Massepotential B des Maschinenwellenlagers 105 isolierten Metallkörper gebildet ist. In Fig. 4 ist mit 2 ein Hochfrequenzgenerator (abgekürzt: HF-Generator) bezeichnet mit einer Impedanz z2 als Innenwiderstand, wobei dieser HF-Generator 2 mit seiner Impedanz z2 ein vereinfachtes Ersatzschaltbild für die von dem Ort einer Teilentladung ausgesendeten elektromagnetischen Wellen darstellt, welche über den Luftspalt s31 (Fig. 3) unter kapazitiver Kopplung in die Welle W eingekoppelt werden, die damit den einen Belag k2 einer Ersatzkapazität bildet, wobei der Ölfilm 1 (vgl. Fig. 1) als Dielektrikum zwischen der Welle W (Belag k2) und dem gegenüberliegenden Kapazitätsbelag k1 (gebildet durch die Lagerschale) wirkt. Die Lagerschale, welche in Fig. 1 verdeckt ist durch das Lagergehäuse 3, liegt mit diesem Lagergehäuse auf dem gleichen Potential, und das Lagergehäuse 3 ist über seine Stützen 3.1 und eine Fußplatte 4 unter Zwischenschaltung einer Isolierschicht 5 auf dem Tragrahmen 107 abgestützt. Letzterer ist Bestandteil des Fundamentrahmens 107 bzw. mit diesem metallisch verbunden und steht demgemäß auf Erdpotential. Wenn man die Potentialverhältnisse am Erregerlager 105 in das Ersatzschaltbild nach Fig. 4 überträgt, so stellt der untere Kapazitätsbelag k3 den auf Erdpotential liegenden Fundamentrahmen 107 dar und das Dielektrikum zwischen den Belägen k1 und k3 wird durch die Isolationsschicht 5 gebildet. Die Ersatzkapazität C mit den Belägen k1, k2 und k3 ist im Schaltbild nach Fig. 5 als Reihenschaltung aus den beiden Teilkapazitäten C1 und C2 dargestellt, wobei die Meßimpedanz z1 an die Verbindungsleitung der beiden Teilkapazitäten C1, C2 angeschlossen zu denken ist. An das dem Massepotential P abegewandte Ende der Meßimpedanz z1 wäre dann das Koppelfilter te3 anzuschließen, wie in Fig. 4 angedeutet; die übrige Anordnung der Meßleitungen m1, m2, des Meßgerätes te1 und der Buchse te2 könnte beibehalten werden.

Sinngemäß zum Ersatzschaltbild nach Fig. 5 könnte für die induktive Auskopplung, wie sie in Fig. 1 schematisch dargestellt ist, ein entsprechendes Ersatzschaltbild angegeben werden.

Durch die beschriebene Auskoppelung der Teilentladungs-Meßsignale aus dem Dipolfeld der Welle W auf induktivem und/oder kapazitivem Wege ergibt sich eine sehr zuverlässige Meßanordnung, weil durch die auf induktivem Wege gewonnenen Signale die auf kapazitivem Wege gewonnenen Meßsignale kontrolliert und verifiziert werden können und umgekehrt. Außerdem hat man durch die Anwendugn beider Methoden die Wahl, diejenige Methode zur Auswertung bevorzugt heranzuziehen, welche das größere Meßsignal liefert.

Auf eine nähere Erläuterung der Teilentladungs-Meßeinrichtung TE-M kann im Rahmen der vorliegenden Anmeldung verzichtet werden, weil diese in der älteren Anmeldung DE-A 3 526 149.8 näher erläutert ist. Auf diese Anmeldung wird zur Vermeidung von Wiederholungen ausdrücklich Bezug genommen. Ferner wird im Zusammenhang mit Aufbau und Wirkungsweise von Teilentladungs-Meßgeräten verwiesen auf den Aufsatz "Wicklungsüberwachung von elektrischen Maschinen durch Hochfrequenz-Meßverfahren" von P. Grünewald, J. Weidner und A. Wichmann, abgedruckt in der Zeitschrift "Siemens-Energietechnik" 6 (1984), S. 286 bis 289. Grundlegende Ausführungen zu Teilentladungsmessungen an Hochspannungstransformatoren als Mittel der Qualitätskontrolle finden sich in einem Fachaufsatz von H. Nieschwietz und W. Stein in der "Elektrotechnischen Zeitschrift etz-a", Band 97 (1976), Heft 11, S. 657 bis 663.

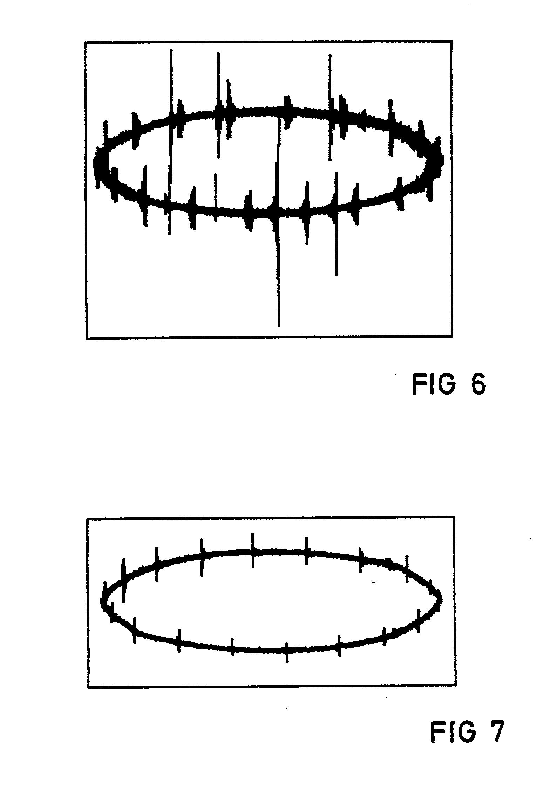

Abschließend seien die beiden Diagramme nach Fig. 6 und 7 erläutert. Die mit einer induktiven Koppelschleife te4 nach Fig. 1 durchgeführten Messungen eines normalen Isolationszustandes der Ständerwicklung eines Turbogenerators einschließlich seiner Generatorableitungen erbrachten ein Diagramm nach Fig. 7. Die 18 Teilentladungs-Spitzen, welche der Zweistrahl-Oszillograph überlagert zu der auf einer elliptischen Zeitachse dargestellten 50 Hz-Grundwelle abgebildet hat, sind auf Schaltvorgänge der Gleichrichter-Dioden zurückzuführen, welche innerhalb des RG-Satzes 101 (vgl. Fig. 3), in Drehstrombrückenschaltung verschaltet, umlaufend angeordnet sind. Diese relativ kleinen Teilentladungs-Spitzen sind als normal bzw. harmlos anzusprechen, wogegen die in ihrer Amplitude wesentlich größeren Teilentladungs-Spitzen nach Fig. 6 auf Impulse zurückzuführen sind, welche durch einen Erdleitungsabriß einer Generator-Schaltleitung verursacht wurden. Aufgrund dieses Diagramms konnte der entsprechende Fehler schnell erkannt, geortet und beseitigt werden.

**Patentansprüche**

1. Verfahren zur Teilentladungserfassung und Abreißfunkenmessung bei dynamoelektrischen Hochspannungsmaschinen, insbesondere zur betriebsmäßigen Überwachung des Isolationszustandes der Ständerwicklung (s4) und der angeschlossenen elektrischen Ableitungen (s7) bei Turbogeneratoren (10), letztere dynamoelektrischen Hochspannungsmaschinen aufweisend einen Ständer (s3, s6) mit Ständerwicklung (s4) und Ständergehäuse (s1) sowie Rotor (r) mit Erregerwicklung und Welle (W, 11, 11.1), ferner mit Luftspalt (13) zwischen Rotor (r) und Ständer (s3, s6), wobei die Welle (W, 11, 11.1) des Rotors (r) an wenigstens einem ölgeschmierten Gleitlager (14,15, 105) gelagert ist, und wobei das bei Auftreten von Teilentladungen (f1, f2) oder Abreißfunken entstehende Frequenzspektrum hochfrequenter elektromagnetischer Schwingungen ausgekoppelt und einer Teilentladungs-Meßeinrichtung (TE-M) zugeführt wird, **dadurch gekennzeichnet,** daß unter Ausnutzung der über den Schmierfilm (1) isolierten Maschinenwelle (W) als Dipol-Antenne das im Falle von Teilentladungen innerhalb der Ständerwicklung (s4) oder ihrer Ableitungen (s7) über den Luftspalt (13) in die Maschinenwelle (W) eingekoppelte Frequenzspektrum hochfrequenter elektromagnetischer Schwingungen auf induktivem und/oder kapazitivem Wege ausgekoppelt und dann der Teilentladungs-Meßeinrichtung (TE-M) zugeführt wird.

2. Verfahren nach Anspruch 1, **dadurch gekennzeichnet,** daß das Frequenzspektrum über wenigstens ein Filter (te3), welches die niederfrequenten Störimpulse unterdrückt, der Teilentladungs-Meßeinrichtung (TE-M) zugeführt wird.

3. Einrichtung zur Durchführung des Verfahrens nach Anspruch 1 oder 2, mit einer Teilentladungs-Meßeinrichtung (TE-M), bestehend aus wenigstens einem Teilentladungs-Meßgerät (te1) und an dieses Meßgerät über Koppelfilter (te3) angeschlossenen Meßleitungen (m1, m2), **dadurch gekennzeichnet,** daß wenigstens eine stationäre induktive Koppelschleife (te4) als Empfangsantenne in unmittelbarer Nachbarschaft der Maschinenwelle (W) an das Dipolfeld der Maschinenwelle angekoppelt und ausgangsseitig an die Meßleitung (m1, m2) angeschlossen ist und/oder daß über eine Ankopplungsimpedanz (z1) eine Meßleitung an einen Kapazitätsbelag (k1) galvanisch angeschlossen ist, welcher Kapazitätsbelag durch eine zur Welle (W, 11, 11.2) und zum Massepotential (B) des Maschinenwellenlagers (105) isolierten Metallkörper gebildet ist.

4. Einrichtung nach Anspruch 3, für Turbogeneratoren mit Erregereinrichtung, **dadurch gekennzeichnet,** daß die induktive Koppelschleife (te4) im Bereich der Erregereinrichtung (100) angeordnet ist.

5. Einrichtung nach Anspruch 4, wobei im Axialbereich der Erregereinrichtung (100) die Maschinenwellen (W) an einem in bezug auf Massepotential (B) isolierten Erregerlager (105) gelagert ist, **dadurch gekennzeichnet,** daß die induktive Koppelschleife (te4) im Bereich des Erregerlagers angeordnet ist.

6. Einrichtung nach Anspruch 3, wobei die dynamoelektrische Hochspannungsmaschine ein Turbogenerator (10) mit Erregereinrichtung (100) ist und wobei im Axialbereich der Erregereinrichtung die Maschinenwelle (W) an einem in bezug auf Masse isolierten Erregerlager (105) gelagert ist, **dadurch gekennzeichnet,** daß über wenigstens eine Ankopplungsimpedanz (z1) die Meßleitungen (m1, m2) direkt kapazitiv an einen zur Welle (W) und zur Masse (B) isolierten Potentialpunkt des Erregerlagers (105) angekoppelt sind.

7. Einrichtung nach Anspruch 6, **dadurch gekennzeichnet,** daß die Ankopplungsimpedanz (z1) an die Lagerschale oder einen damit galvanisch verbundenen Metallkörper (3) der Erregerlagers (105) angeschlossen ist.

**Claims**

1. A method for the detection of partial discharges and for measuring break sparks in dynamoelectric high-voltage machines, in particular for monitoring, during operation, of the insulation state of the stator winding (s4) and of the connected electrical end leads (s7) in turbine-generators (10), the latter dynamo-electric high-voltage machines having a stator (s3, s6) with a stator winding (s4) and stator housing (s1) as well as a rotor (r) with an excitation winding and shaft (W, 11, 11.1), furthermore with an air gap (13) between the rotor (r) and stator (s3, s6), wherein the shaft (W, 11, 11.1) of the rotor (r) is supported on at least one oil-lubricated sliding bearing (14, 15, 105) and wherein the frequency spectrum of high-frequency electromagnetic oscillations occurring with partial discharges (f1, f2) or break sparks is decoupled and supplied to a partial-discharge measuring device (TE-M), characterised in that with use of the machine shaft (W) insulated by the lubricant film (1) as dipole antenna the frequency spectrum of high-frequency electro magnetic oscillations, coupled in the case of partial discharges within the stator winding (s4) or its end leads (s7) by way of the air gap (13) at the machine shaft (W), is decoupled inductively and/or capacitively and then supplied to the partial-discharge measuring device (TE-M).

2. A method according to claim 1, characterised in that the frequency spectrum is supplied by way of at least one filter (te3), which suppresses the low-frequency interfering pulses, to the partial-discharge measuring device (TE-M).

3. A device for carrying out the method according to claim 1 or 2, with a partial-discharge measuring device (TE-M), consisting of at least one partial-discharge measuring apparatus (te1) and measuring lines (m1, m2) connected to this measuring apparatus by way of coupling filters (te3), characterised in that at least one stationary inductive coupling loop (te4) is coupled as receiving antenna in the direct vicinity of the machine shaft (W) to the dipole field of the machine shaft and is connected on the output side to the measuring lines (m1, m2), and/or in that by way of a coupling impedance (z1) a measuring line is connected electrically to a capacitance layer (k1), which capacitance layer is formed by a metal body insulated from the shaft (W, 11, 11.2) and from earth potential (B) of the machine shaft bearing (105).

4. A device according to claim 3, for turbine-generators with an excitation device, characterised in that the inductive coupling loop (te4) is disposed in the region of the excitation device (100).

5. A device according to claim 4, wherein in the axial region of the excitation device (100) the machine shaft (W) is supported on an exciter bearing (105) insulated from earth potential (B), characterised in that the inductive coupling loop (te4) is arranged in the region of the exciter bearing.

6. A device according to claim 3, wherein the dynamo-electric high-voltage machine is a turbine-generator (10) with an excitation device (100), and wherein in the axial region of the excitation device the machine shaft (W) is supported on an exciter bearing (105), insulated from earth, characterised in that by way of at least one coupling impedance (z1) the measuring lines (m1, m2) are coupled directly capacitively to one potential point of the exciter bearing (105) insulated from the shaft (W) and from the earth (B).

7. A device according to claim 6, characterised in that the coupling impedance (z1) is connected to the bearing shell, or a metal body (3) of the exciter bearing (105) connected electrically to said shell.

**Revendications**

1. Procédé pour détecter des décharges partielles et mesurer des étincelles de rupture dans des machines dynamo-électriques à haute tension, notamment pour le contrôle en fonctionnement de l'état d'isolation de l'enroulement statorique (s4) et des conducteurs électriques de dérivation raccordés (s7), dans des turboalternateurs (10), les machines dynamo-électriques à haute tension comportant un stator (s3, s6) possédant un enroulement statorique (s4) et un carter de stator (s) ainsi qu'un rotor (r) comportant un enroulement d'excitation et un arbre (W, 11, 11.1), avec en outre un entrefer (13) entre le rotor (r) et le stator (s3, s6), et dans lequel l'arbre (W, 11, 11.1) du rotor (r) est supporté au moins par un palier lisse (14, 15, 105) lubrifié par huile et le spectre de fréquences d'oscillations électromagnétiques à haute fréquence, qui apparaît lors de l'apparition de décharges partielles (f1, f2) ou d'étincelles de rupture, est extrait par découplage et est envoyé à un dispositif (TE-M) de mesure de décharges partielles, caractérisé par le fait que dans le cas d'utilisation de l'arbre (W) de la machine, isolé par l'intermédiaire de la pellicule lubrifiante (1), en tant qu'antenne en forme de dipôle, le spectre de fréquence d'oscillations électromagnétiques à haute fréquence, injecté par couplage par l'intermédiaire de l'entrefer (13) dans l'arbre (W) de la machine dans le cas de décharges partielles à l'intérieur de l'enroulement statorique (s4) ou de ses conducteurs de dérivation (s7), est extrait par découplage d'une manière inductive et/ou capacitive et est ensuite envoyé au dispositif (TE-M) de mesure de décharges partielles.

2. Procédé suivant la revendication 1, caractérisé par le fait que le spectre de fréquence est envoyé au dispositif (TE-M) de mesure de décharges partielles, par l'intermédiaire d'au moins un filtre (te3), qui élimine les impulsions parasites à basse fréquence.

3. Dispositif pour la mise en œuvre du procédé suivant la revendication 1 ou 2, comportant un dispositif (TE-M) de mesure de décharges partielles, constitué par au moins un appareil (tel) de mesure de décharges partielles et par des conducteurs de mesure (m1, m2) raccordés à cet appareil de mesure par l'intermédiaire de filtres de couplage (te3), caractérisé par le fait qu'au moins une boucle fixe inductive de couplage (te4) est accouplée, sous la forme d'une antenne de réception au voisinage immédiat de l'arbre (W) de la machine, au champ dipolaire de l'arbre de la machine et, côté sortie, est raccordé au conducteur de mesure (m1, m2), et/ou qu'un conducteur de mesure est raccordé galvaniquement par l'intermédiaire d'une impédance de couplage (z1), à une armature (k1) d'un condensateur, qui est formée par un corps métallique isolé par rapport à l'arbre (W, 11, 11.2) et au potentiel de masse (B) du palier (105) soutenant l'arbre de la machine.

4. Dispositif suivant la revendication 3, pour des turboalternateurs comportant un dispositif d'excitation, caractérisé par le fait que la boucle inductive de couplage (te4) est disposée au voisinage du dispositif d'excitation (100).

5. Dispositif suivant la revendication 4, dans lequel l'arbre (W) de la machine est tourillonné, dans la zone axiale du dispositif d'excitation (100), sur un palier (105) du dispositif d'excitation, isolé par rapport au potentiel de masse (B), caractérisé par le fait que la boucle inductive de couplage (te4) est disposée dans la zone du palier du dispositif d'excitation.

6. Dispositif suivant la revendication 3, dans lequel la machine dynamo-électrique à haute tension est un turboalternateur (10) comportant un dispositif d'excitation (100) et dans lequel l'arbre (W) de la machine est tourillonné, dans la zone axiale du dispositif d'excitation, dans un palier (105) de ce dispositif d'excitation, isolé par rapport à la masse, caractérisé par le fait que les conducteurs de mesure (m1, m2) sont accouplés directement de façon capacitive, par l'intermédiaire d'au moins une impédance de couplage (z1), à un point de potentiel, isolé par rapport à l'arbre (W) et à la masse (B), du palier (105) du dispositif d'excitation.

7. Dispositif suivant la revendication 6, caractérisé par le fait que l'impédance de couplage (z1) est raccordée au coussinet de palier ou à un corps métallique (3), relié galvaniquement à ce coussinet, du palier (105) du dispositif d'excitation.

FIG 1

FIG 3

FIG 2

FIG 4

FIG 5

FIG 6

FIG 7